# EUROPÄISCHE PATENTSCHRIFT

(11) **EP 4 175 095 B1**
(45) Veröffentlichungstag und Bekanntmachung des Hinweises auf die Patenterteilung: **24.04.2024**
(21) Anmeldenummer: 22201796.4
(22) Anmeldetag: 17.10.2022
(51) Int. Cl.: H02H 3/16, G01R 31/08, H02H 3/33

(54) **VERFAHREN UND VORRICHTUNG ZUR ERKENNUNG UND LOKALISIERUNG VON ZYKLISCHEN KURZZEIT-ISOLATIONSFEHLERN IN EINEM UNGEERDETEN STROMVERSORGUNGSSYSTEM**
METHOD AND APPARATUS FOR DETECTING AND LOCATING SHORT-TERM CYCLIC INSULATION FAULTS IN AN UNEARTHED POWER SUPPLY SYSTEM
PROCÉDÉ ET DISPOSITIF DE DÉTECTION ET DE LOCALISATION D'ERREURS CYCLIQUES D'ISOLATION DE COURTE DURÉE DANS UN SYSTÈME D'ALIMENTATION ÉLECTRIQUE NON MIS À LA TERRE

(30) Priorität: 26.10.2021 DE 102021127848
(43) Veröffentlichungstag der Anmeldung: 03.05.2023
(73) Patentinhaber: Bender GmbH & Co. KG, 35305 Grünberg (DE)
(72) Erfinder: Hackl, Dieter, 35463 Fernwald (DE); Schepp, Karl, 35447 Reiskirchen (DE); Becker, Pascal, 35305 Grünberg (DE)
(74) Vertreter: advotec.

(56) Entgegenhaltungen:
- EP-A1- 2 851 692
- DE-A1-102009 037 445
- RU-C1- 2 744 995
- US-A1- 2020 166 556

## Beschreibung

Die Erfindung betrifft ein Verfahren und eine Vorrichtung zur Erkennung und Lokalisierung von zyklisch auftretenden Kurzzeit-Isolationsfehlern in einem ungeerdeten Stromversorgungssystem mit einem über einen Leitungszweig angeschlossenen Verbraucher, wobei mit einem Differenzstromsensor ein durch den Kurzzeit-Isolationsfehler verursachter Fehlerstrom als Differenzstrom in einem zu überwachenden Leitungszweig des Stromversorgungssystems erfasst wird und der zeitliche Verlauf dieses Differenzstroms durch ein Differenzstromsignal abgebildet wird.

Bei erhöhten Anforderungen an die Betriebs-, Brand- und Berührungssicherheit kommt die Netzform eines ungeerdeten Stromversorgungssystems zum Einsatz, die auch als isoliertes Netz (frz. Isolé Terre - IT) oder als IT-System bezeichnet wird.

Bei dieser Art des Stromversorgungssystems sind die aktiven Teile des Netzes von dem Erdpotenzial getrennt - gegen Erde isoliert - oder über eine hochohmige Impedanz mit Erde verbunden.

Der Vorteil dieser Netze liegt darin, dass bei einem Isolationsfehler (erster Fehler), wie beispielsweise einem Erdschluss oder einem Körperschluss, die Funktion der angeschlossenen elektrischen Verbraucher nicht beeinträchtigt wird, da sich wegen des im Idealfall unendlich großen Impedanzwertes zwischen einem aktiven Leiter des Netzes und Erde kein geschlossener Fehlerstromkreis ausbilden kann.

Durch diese inhärente Sicherheit des ungeerdeten Stromversorgungssystems kann somit eine kontinuierliche Stromversorgung der von dem ungeerdeten Stromversorgungssystem gespeisten Verbraucher auch dann gewährleistet werden, wenn ein erster Isolationsfehler auftritt.

Der Widerstand des ungeerdeten Stromversorgungssystems gegen Erde (Isolationswiderstand - im Fehlerfall auch Isolationsfehlerwiderstand oder Fehlerwiderstand) muss daher ständig überwacht werden, da durch einen möglichen weiteren Fehler an einem anderen aktiven Leiter (zweiter Fehler) eine Fehlerschleife entstünde und der dabei fließende Fehlerstrom in Verbindung mit einer Überstrom-Schutzeinrichtung eine Abschaltung der Anlage mit Betriebsstillstand zur Folge hätte.

Unter der Voraussetzung, dass der Isolationszustand des ungeerdeten Stromversorgungssystems kontinuierlich von einem der Norm IEC 61557-8 gemäßen Isolationsüberwachungsgerät (Insulation Monitoring Device - IMD) überwacht wird, kann das ungeerdete Stromversorgungssystem auch bei einem aufgetretenen ersten Fehler ohne vorgeschriebene Zeitlimitierung weiterbetrieben werden, jedoch gilt die Empfehlung, den ersten Fehler so schnell wie praktisch möglich zu beseitigen.

Um die Anforderung nach der schnellen Beseitigung des ersten Fehlers zu erfüllen, stellt insbesondere in ausgedehnten, weit verzweigten ungeerdeten Stromversorgungssystemen mit einer Vielzahl von Leitungszweigen der Einsatz eines Isolationsfehlerlokalisierungssystems/Isolationsfehlersucheinrichtung (Insulation Fault Location System - IFLS) - wie in der Produktnorm IEC 61557-9 beschrieben - den Stand der Technik dar. Das Isolationsfehlerlokalisierungssystem umfasst im Wesentlichen einen Prüfstromgenerator und mehrere meist als Messstromwandler ausgeführte Prüfstromsensoren, die zur Auswertung der Messsignale mit einer Auswerteeinheit des Isolationsfehlerlokalisierungssystems verbunden sind. Ist in dem ungeerdeten Stromversorgungssystem ein erster Isolationsfehler von dem Isolationsüberwachungsgerät erkannt worden, startet die Isolationsfehlersuche, indem der Prüfstromgenerator einen Prüfstrom erzeugt und diesen an zentraler Stelle in das ungeerdete Stromversorgungssystem zwischen einem oder mehreren aktiven Leitern und Erde einspeist. Es entsteht ein geschlossener Prüfstromkreis, in dem der Prüfstrom von dem Prüfstromgenerator über die spannungsführenden aktiven Leiter, den Isolationsfehler und über eine Erdverbindung zurück zu dem Prüfstromgenerator fließt.

Die Lokalisierung des Fehlerortes erfolgt über eine Detektion des Prüfstroms, der in dem ungeerdeten Stromversorgungssystem durch Prüfstromsensoren erfassbar ist. Dazu ist jedem zu überwachenden Leitungszweig ein Prüfstromsensor fest zugeordnet, sodass der Pfad des Prüfstroms nachverfolgt werden kann. Durch die bekannte Zuordnung der Prüfstromsensoren zu den Leitungszweigen kann der Fehlerort lokalisiert werden.

Dokument US 2020/166556 A1 enthüllt eine Vorrichtung zur Erkennung intermittierender Erdfehler in einem nicht geerdeten Stromversorgungssystem. Diese Vorrichtung umfasst eine Erfassungseinheit und einen Server. Die Erfassungseinheit erfasst, speichert und überträgt einen zeitlichen Verlauf von elektrischen Feldmessungen an den Server. Dieser Server empfängt die Messungen und korreliert sie mit den Daten einer Wetterstation, um intermittierende Erdfehler zu identifizieren. Der wesentliche Unterschied zu den unabhängigen Ansprüchen liegt somit in der Art der gemessenen elektrischen Größe (z.B. elektrisches Feld anstelle von Differenzströmen) und der Art der korrelierten Größe (z.B. Wetterdaten statt des Prozessablaufs eines Verbrauchers).

Ein bislang nicht zufriedenstellend gelöstes Problem bei dem industriellen Einsatz der Netzform IT-System besteht darin, dass regelmäßig wiederkehrende (zyklische) und nur kurzzeitig auftretende Isolationsfehler in Anlagen und Maschinen mit den normgemäßen Isolationsüberwachungsgeräten nach dem aktuellen Stand der Technik weder zuverlässig erkannt noch mit normgemäßen Isolationsfehlersuchsystemen nach dem aktuellen Stand der Technik zufriedenstellend lokalisiert werden können.

Selbst sehr schnell arbeitende Isolationsüberwachungsgeräte in kleineren IT-Systemen mit geringen Ableitkapazitäten benötigen eine Messzeit im Sekundenbereich, um den Isolationswiderstand zu bestimmen. Auch sehr schnell arbeitende Isolationsfehlersuchsysteme benötigen zur Lokalisierung fehlerhafter Leitungszweige Zeiten im Bereich von Minuten.

Isolationsfehler, die einen zyklisch, also regelmäßig wiederkehrenden, je nach Prozess auch nur jede Stunde oder seltener, und dabei kurzzeitig auftretenden Fehlerstrom mit einer Dauer von einigen Millisekunden bis zu einigen hundert Millisekunden verursachen, werden von typischen Isolationsüberwachungsgeräten und/oder Isolationsfehlersuchsystemen meist wie ein Störeinfluss behandelt und daher unterdrückt. Da insbesondere in industriellen IT-Systemen typischerweise Umrichtersysteme zum Einsatz kommen, sind Störungen, die betriebsbedingt auftreten, mit Isolationsüberwachungsgeräten und Isolationsfehlersuchsystemen nach dem Stand der Technik von den hier betrachteten zyklisch und kurzzeitig auftretenden Isolationsfehlern nicht zu unterscheiden. Ohne die dem Stand der Technik entsprechende Störunterdrückung würden daher die Überwachungs- und Lokalisierungssysteme laufend Fehlalarmmeldungen ausgeben und wären somit in industriellem Umfeld nicht einsetzbar.

Die hier betrachteten zyklisch und kurzzeitig auftretenden Isolationsfehler, wie sie beispielsweise durch ein Versorgungskabel für ein prozessabhängig bewegtes Teil einer Produktionsanlage, welches zyklisch über ein geerdetes und leitfähiges metallisches Teil geschliffen wird, auftreten, haben, bedingt durch den inhärenten Weiterbetrieb bei einem ersten Fehler in dem IT-System, typischerweise selbst über Monate hinweg keinen vernehmbaren Einfluss auf den Produktionsprozess. Derartige Isolationsfehler bleiben somit zunächst unerkannt.

Allerdings führen Umladevorgänge von parasitär immer vorhandenen Netzableitkapazitäten im IT-System bei jedem dieser zyklisch und kurzzeitig auftretenden Isolationsfehler zu einem (Fehler-)Stromfluss und damit zu einer zusätzlichen elektrischen und thermischen Belastung der festen Isolierung im Umfeld der Fehlerstelle.

Über einen längeren Zeitraum hinweg ist daher eine zunehmende Degradation der elektrischen Isolation an der Fehlerstelle zu erwarten, und es steigt das Risiko, dass es bei einem zweiten Isolationsfehler in einem anderen Teil der Anlage zu einer Abschaltung des kompletten Stromversorgungssystems durch Überstromschutzeinrichtungen kommt. Gerade dies jedoch soll mit dem Einsatz der Netzform IT-System möglichst vermieden werden.

Mit dem Einsatz der aus dem Stand der Technik bekannten Isolationsüberwachungsgeräte und Isolationsfehlersuchsysteme wird es bei fortschreitender Degradation durch den hier betrachteten zyklisch und kurzzeitig auftretenden Isolationsfehler daher immer wahrscheinlicher, dass der fehlerhafte Zweig aufgrund des sinkenden Isolationswiderstands entdeckt wird. Je länger allerdings der fehlerhafte Zustand unentdeckt besteht, desto größer wird auch die Wahrscheinlichkeit einer automatischen Abschaltung der Stromversorgung für die gesamte Anlage durch einen zweiten Fehler in einem anderen Teil der Anlage. Dies gilt es zu vermeiden.

Bei IT-Systemen, die mit Isolationsüberwachungsgeräten und Isolationsfehlersuchsystemen nach dem Stand der Technik ausgerüstet sind, kann es bei weitverzweigten IT-Systemen mit einer erheblichen Anzahl von Leitungszweigen und demzufolge mit sehr großen Netzableitkapazitäten bei kurzzeitig auftretenden Isolationsfehlern mit nahezu vernachlässigbarer Impedanz dazu kommen, dass Überstromschutzeinrichtungen mit einer entsprechend empfindlichen Charakteristik eine Abschaltung des fehlerhaften Leitungszweigs bewirken. Ob diese Abschaltung tatsächlich zuverlässig erfolgt und ob sie früher erfolgen würde als eine Erkennung von Isolationsfehlern bei dem Einsatz von Isolationsüberwachungsgeräten und Isolationsfehlersuchsystemen nach dem Stand der Technik, ist von sehr vielen Anlagenparametern abhängig und daher schwierig zu beurteilen.

Auch ist zur Erkennung von zyklisch auftretenden und kurzzeitigen Isolationsfehlern der Einsatz von Fehlerstrom-Schutzeinrichtungen (RCD, MRCD) für den Fehlerschutz denkbar.

Die Kombination von hinreichend großen Netzableitkapazitäten im IT-System und niederohmigen, kurzzeitig auftretenden Isolationsfehlern in Verbindung mit einer passend gewählten Ansprechempfindlichkeit der Fehlerstrom-Schutzeinrichtung kann zur Abschaltung des fehlerhaften Leitungszweiges führen. Die Auslegung dieser Kombination ist allerdings nur mit erheblichem Aufwand so zu realisieren, dass Fehlabschaltungen bei Störungen, wie beispielsweise durch den Umrichterbetrieb, minimiert werden. Da die im industriellen Bereich vorkommenden Laststromänderungen sehr störenden Einfluss auf die Fehlerstromschutz-Einrichtungen haben, wird der Einsatz in Umrichterumgebungen meistens vermieden.

Bekannt ist auch, die schnelle Erfassung von Verlagerungsspannungen zwischen Netz und Erde zur Erdschlusswischer-Erkennung zu verwenden. Mit diesem Verfahren ist es aber nicht möglich, den fehlerhaften Leitungszweig zu entdecken und das alleinige Kriterium der Verlagerungsspannung kann zu ungewollten Fehlmeldungen führen.

Der vorliegenden Erfindung liegt somit die Aufgabe zugrunde, ein Verfahren und eine Vorrichtung zur Erkennung und Lokalisierung von zyklisch und kurzzeitig auftretenden Isolationsfehlern in einem ungeerdeten Stromversorgungssystem vorzuschlagen.

Diese Aufgabe wird mit einem Verfahren in Verbindung mit dem Oberbegriff des Anspruchs 1 gelöst durch Bereitstellen eines Prozesssignals, welches einen Prozessablauf eines in dem Verbraucher ablaufenden Prozesses zeitlich beschreibt, Korrelieren des Differenzstromsignals mit dem Prozesssignal in einer Recheneinheit, um ein Korrelationssignal als Maß für eine zeitliche Übereinstimmung zwischen dem Differenzstromsignal und dem Prozesssignal zu erhalten, Signalisieren des Kurzzeit-Isolationsfehlers durch die Recheneinheit mittels eines Signalisierungssignals, falls das Korrelationssignal die zeitliche Übereinstimmung zeigt.

Der Grundgedanke der vorliegenden Erfindung beruht darauf, das Differenzstromsignal von hinreichend empfindlichen Differenzstromsensoren, welche in jedem zu überwachenden Leitungszweig eines verzweigten ungeerdeten Stromversorgungssystems installiert sind, in Korrelation zu einem einen Prozessablauf beschreibenden Prozesssignal zu bringen, um Störungen von zyklisch und kurzzeitig auftretenden Isolationsfehlern zuverlässig erkennen und von anderen Störeinflüssen sicher unterscheiden zu können. Der Prozess kann dabei ein beliebiger in dem Verbraucher ablaufender Prozess sein, wie beispielsweise ein Produktions- oder Fertigungsprozess, der mit einem bestimmten Prozessablauf (Prozesszyklus) und einem erfassbaren Prozessparameter oder einem Steuersignal verbunden ist.

Dazu sind zunächst unabhängig von dem Prozessablauf in jedem zu überwachenden Leitungszweig des verzweigten, ungeerdeten Stromversorgungssystems Differenzstromsensoren angeordnet, um den in diesem Leitungszweig fließenden Fehlerstrom, der infolge eines Isolationsfehlers über den zu überwachenden Leitungszweig als Differenzstrom fließt, zu erfassen. Der zeitliche Verlauf dieses Differenzstroms wird von dem jeweiligen Differenzstromsensor in Form des Differenzstromsignals abgebildet und an eine Recheneinheit weitergeleitet.

Zeitlich parallel dazu wird ein Prozesssignal bereitgestellt, das einen bestimmten Prozessablauf innerhalb des Prozesses beschreibt und damit seinerseits zeitlich mit dem Prozess korreliert ist.

Zur Weiterverarbeitung in einer erfindungsgemäßen Recheneinheit stehen somit das Differenzstromsignal und das Prozesssignal zur Verfügung. In der Recheneinheit wird das Differenzstromsignal mit dem Prozesssignal korreliert, um die Ähnlichkeit beider Signale zu prüfen. Dazu wird ein Korrelationssignal als Maß für eine zeitliche Übereinstimmung gebildet, um zu erkennen, ob eine zeitliche Synchronität beider Signale, beispielsweise durch übereinstimmende Musterverläufe, vorliegt.

Zeigt das Korrelationssignal eine zeitliche Übereinstimmung des Differenzstromsignals mit dem Prozesssignal, weisen beide Signale also einen hohen Ähnlichkeitsgrad auf, so signalisiert die Recheneinheit, dass ein Kurzzeit-Isolationsfehler vorliegt. Da die Zuordnung des Differenzstromsensors, welcher das in die Korrelation einbezogene Differenzstromsignal erzeugt hat, zu dem Leitungszweig bekannt ist, ist damit der fehlerhafte Leitungszweig lokalisiert.

Das Verfahren ist dabei in vorteilhafter Weise weitgehend universell in industriellen Anwendungen wirksam, ohne dass Systemparameter wie beispielsweise die Größe der Netzableitkapazität in engen Grenzen eingehalten werden müssen.

Damit sind gegenüber dem Stand der Technik erfindungsgemäß weniger Fehlabschaltungen und weniger unverhoffte komplette Anlagenausfälle zu erwarten.

In weiterer vorteilhafter Ausgestaltung wird das Prozesssignal mittels einer Sensoreinrichtung durch Erfassen eines mit dem Prozess verbundenen Prozessparameters und durch Abbilden des zeitlichen Verlaufs des Prozessparameters erzeugt.

Über das ungeerdete Stromversorgungssystem werden die angeschlossenen Verbraucher mit Energie versorgt. Die in dem Verbraucher ablaufenden Prozesse sind wiederum mit zeitlichen Verläufen von Prozessparametern verbunden. Diese Prozessparameter, wie beispielsweise ein Laststromverlauf einer als Verbraucher angeschlossenen elektrischen Maschine oder ein Bewegungsablauf eines beweglichen Teils des angeschlossenen Betriebsmittels, werden mittels einer Sensoreinrichtung erfasst und durch ein Prozesssignal in ihrem zeitlichen Verlauf abgebildet. Dieses Prozesssignal wird in die Korrelationsberechnung mit dem Differenzstromsignal einbezogen.

Die Sensorik zur Bereitstellung des Prozesssignals in Verbindung mit den Korrelationsberechnungen zur Prüfung auf Synchronität des Differenzstromsignals mit dem Prozesssignal ermöglicht die zuverlässige Unterscheidung zwischen kurzzeitigen Störereignissen, wie sie beispielsweise bei einem Umrichterbetrieb auftreten, von den zu detektierenden zyklischen, jedoch nur sehr kurzzeitig auftretenden Isolationsfehlern.

Mit Vorteil wird als Prozessparameter eine den Prozessablauf beschreibende physikalische Größe oder eine daraus abgeleitete Größe erfasst.

Grundsätzlich kann der das Prozesssignal darstellende Prozessparameter eine beliebige in ihrem zeitlichen Verlauf messbare physikalische Größe sein. In Abhängigkeit der Art des betrachteten Prozesses kommen dabei als elektrische Größen insbesondere die Erfassung eines Laststroms (Laststromsignal) oder einer elektrischen Spannung sowie messbare mechanische oder geometrische Größen wie Masse, Länge, Winkel oder ein Druckverlauf in Frage. Insbesondere kann aus dem Bewegungsablauf eines beweglichen Teils über die Zeit ein Bewegungssignal als Prozesssignal abgeleitet werden. Darüber hinaus können auch thermodynamische Größen wie die Temperatur oder optische Größen wie die Lichtstärke mit geeigneten Sensoreinrichtungen als Prozessparameter zum Abbilden des zeitlichen Verlaufs durch ein Prozesssignal ausgewertet werden.

Weiterhin wird als Prozesssignal ein den Prozessablauf leitendes Steuersignal korreliert.

In Ergänzung oder alternativ zu dem von der Sensoreinrichtung erzeugten Prozesssignal wird als Prozesssignal ein den Prozessablauf leitendes Steuersignal von einer - nicht von der Erfindung umfassten - Prozessablaufsteuerung unmittelbar genutzt. In diesem Fall ist die Sensoreinrichtung entbehrlich und das von einer Prozessablaufsteuerung bereitgestellte Steuersignal wird als Prozesssignal in die Korrelationsberechnung mit dem Differenzstromsignal einbezogen. Das Steuersignal beinhaltet vorzugsweise eine digitale Information über den Prozessablauf.

Weiter wird als Verlagerungsspannungssignal der zeitliche Verlauf einer Verlagerungsspannung zwischen einem aktiven Leiter des ungeerdeten Stromversorgungssystems und Erde mittels einer Spannungsmesseinrichtung erfasst und in der Recheneinheit mit dem Differenzstromsignal korreliert.

Wird das Stromversorgungssystem in einer gestörten Systemumgebung betrieben, beispielsweise bei Umrichterbetrieb, kann zusätzlich die Verlagerungsspannung eines oder mehrerer Leiter gegen Erde erfasst werden, um durch die Einbeziehung des Verlagerungsspannungssignals in die Korrelationsberechnungen die Störresistenz zu erhöhen. Das verbesserte Störverhalten resultiert dabei in Verbindung mit der Erfassung eines Laststromverlaufs als Prozesssignal auf folgenden Erkenntnissen: Ein Differenzstromsignal, welches mit dem Laststromverlauf korreliert, jedoch nicht mit dem Verlauf der Verlagerungsspannung, ist mit hoher Wahrscheinlichkeit ein Störsignal. Ein Differenzstromsignal, welches mit der Verlagerungsspannung korreliert, jedoch nicht mit dem Verlauf des Laststroms, basiert mit hoher Wahrscheinlichkeit auf einem kurzzeitig auftretenden Isolationsfehler.

Durch die Korrelation des Differenzstromsignals mit einem den Prozessablauf beschreibenden Prozesssignal eines zu überwachenden Anlagenteils (eines zu überwachenden Verbrauchers) sowie bei Bedarf einer zusätzlichen Verknüpfung des Differenzstromsignals mit dem Verlauf eines Laststroms und der Verlagerungsspannung wird somit eine zuverlässige Erkennung und Lokalisierung des durch den zyklisch und kurzzeitig auftretenden Isolationsfehler beeinträchtigten Leitungszweiges gewährleistet.

Die Erfindung wird weiterhin gelöst durch eine Vorrichtung zur Erkennung und Lokalisierung von zyklisch auftretenden Kurzzeit-Isolationsfehlern in einem ungeerdeten Stromversorgungssystem mit einem über einen Leitungszweig angeschlossenen Verbraucher gemäß Anspruch 6, wobei in Verbindung mit den Merkmalen des Oberbegriffs die Vorrichtung gekennzeichnet ist durch eine Recheneinheit, die konfiguriert ist zum Empfangen eines Prozesssignals, welches einen Prozessablauf eines in dem Verbraucher ablaufenden Prozesses zeitlich beschreibt, zum Korrelieren des Differenzstromsignals mit dem Prozesssignal, um ein Korrelationssignal als Maß für eine zeitliche Übereinstimmung zwischen dem Differenzstromsignal und dem Prozesssignal zu erhalten und zum Signalisieren eines Kurzzeit-Isolationsfehlers mittels eines Signalisierungssignals, falls das Korrelationssignal die zeitliche Übereinstimmung zeigt.

Die beanspruchten strukturellen Merkmale der erfindungsgemäßen Vorrichtung führen die entsprechenden Verfahrensschritte des erfindungsgemäßen Verfahrens aus. Somit treffen die mit dem Verfahren erzielten technischen Wirkungen und die daraus resultierenden Vorteile gleichermaßen auch auf die Vorrichtung zu.

Weitere vorteilhafte Ausgestaltungsmerkmale ergeben sich aus der nachfolgenden Beschreibung und den Zeichnungen, die eine bevorzugte Ausführungsform der Erfindung anhand von Beispielen erläutern.

Es zeigen:
- **Fig. 1**: einen erfindungsgemäßen Verfahrensablauf,
- **Fig. 2**: eine erfindungsgemäße Vorrichtung zur Erkennung und Lokalisierung von zyklisch auftretenden Kurzzeit-Isolationsfehlern in einem ungeerdeten dreiphasigen (3AC) Stromversorgungssystem und
- **Fig. 3**: eine erfindungsgemäße Vorrichtung zur Erkennung und Lokalisierung von zyklisch auftretenden Kurzzeit-Isolationsfehlern in einem ungeerdeten Gleichspannungs-(DC)-Stromversorgungssystem.

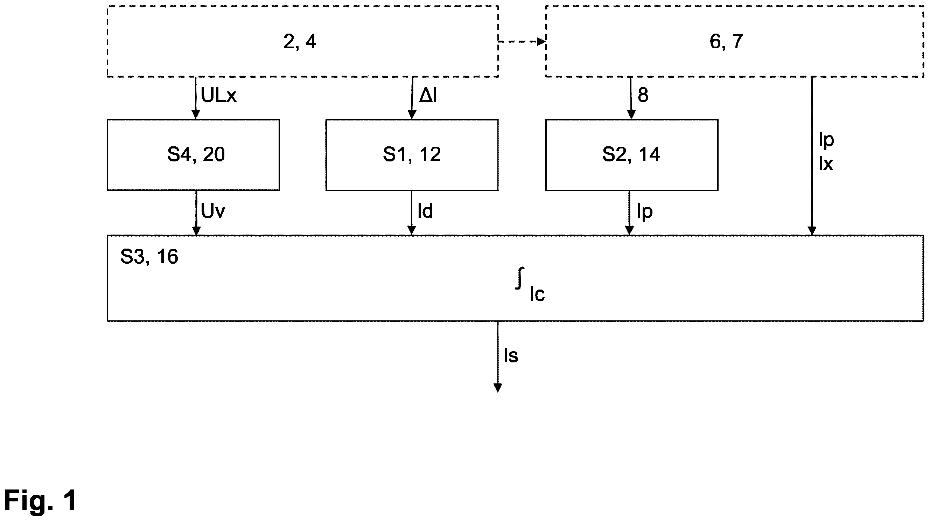

**Fig. 1** zeigt ausgehend von einem ungeerdeten Stromversorgungssystem 2 mit einem angeschlossenen Verbraucher 6 das erfindungsgemäße Zusammenwirken der Verfahrensschritte S1 bis S4 des Verfahrens zur Erkennung und Lokalisierung von zyklisch auftretenden Kurzzeit-Isolationsfehl ern.

In Schritt S1 wird mittels eines Differenzstromsensors 12 ein Differenzstrom ΔI in einem zu überwachenden Leitungszweig 4 erfasst und als Differenzstromsignal Id an eine Recheneinheit 16 weitergeleitet.

Zeitlich parallel dazu wird in Schritt S2 ein Prozessparameter 8 eines in dem Verbraucher 6 ablaufenden Prozesses mittels einer Sensoreinrichtung 14 erfasst und in seinem Zeitverlauf als Prozesssignal Ip ebenfalls an die Recheneinheit 16 übermittelt. Als ergänzendes oder alternatives Prozesssignal Ip kann der Recheneinheit 16 ein Steuersignal Ix unmittelbar von einer Prozessablaufsteuerung 7 zugeleitet werden.

In Schritt S3 wird das Differenzstromsignal Id mit dem Prozesssignal Ip in der Recheneinheit 16 korreliert (verglichen), um zu erkennen, inwieweit die Zeitverläufe eine Übereinstimmung (Ähnlichkeit) zeigen, also eine zeitliche Synchronität aufweisen. Dazu wird ein Korrelationssignal Ic berechnet und ein Signalisierungssignal Is erzeugt, falls das Korrelationssignal Ic als Maß für die Ähnlichkeit beider Signale eine zeitliche Übereinstimmung zwischen dem Differenzstromsignal Id und dem Prozesssignal Ip, beispielsweise durch Überschreitung vorbestimmter Schwellwerte oder Signalverläufe mit ausgeprägten Maxima, zeigt.

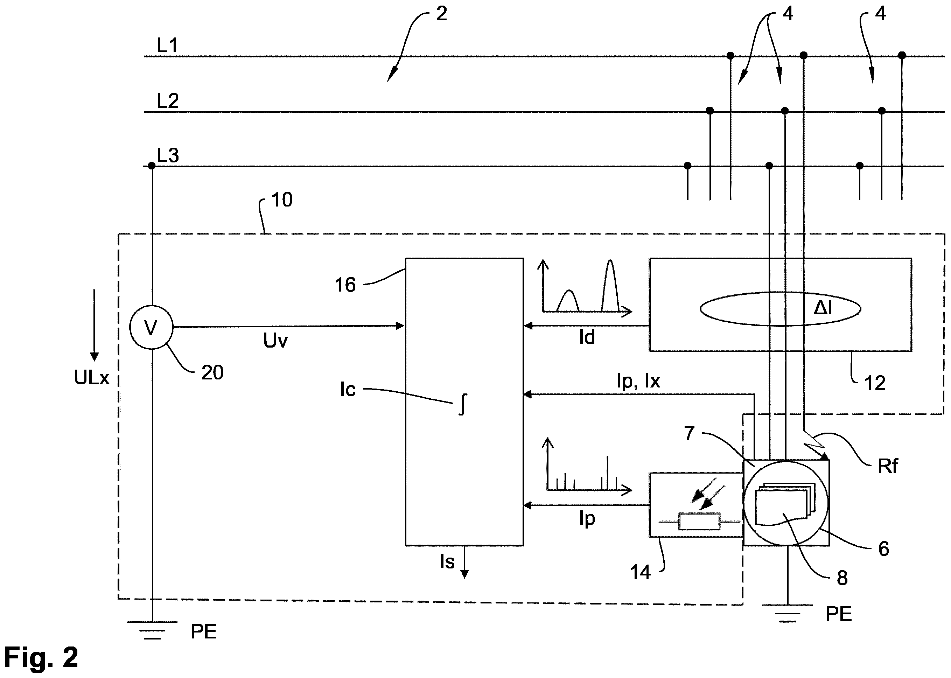

In **Fig. 2** ist in einem funktionalen Blockdiagramm eine erfindungsgemäße Vorrichtung 10 zur Erkennung und Lokalisierung von zyklisch auftretenden Kurzzeit-Isolationsfehlern Rf dargestellt.

Als Systemumgebung für die Anwendung der Erfindung wird grundsätzlich ein ein-oder mehrphasiges IT-System 2 angenommen. Fig. 2 zeigt ein dreiphasiges ungeerdetes Stromversorgungssystem 2 mit aktiven Leitern L1, L2, L3 und zu überwachenden Leitungszweigen 4 dargestellt, an die Verbraucher 6 angeschlossen sind.

Ein Differenzstromsensor 12 erfasst den Differenzstrom ΔI in dem Leitungszweig 4 und erzeugt das Differenzstromsignal Id, welches der Recheneinheit 16 zugeführt wird.

Eine Prozessablaufsteuerung 7 - die nicht Bestandteil der Erfindung ist - steuert den in dem Verbraucher 6 ablaufenden Prozess, wobei zeitgleich mit der Überwachung des Differenzstroms ΔI der Prozessparameter 8 mittels der Sensoreinrichtung 14 erfasst wird. Die Sensoreinrichtung 14 erzeugt ein dem Zeitverlauf des erfassten Parameters 8 entsprechendes Prozesssignal Ip, welches an die Recheneinheit 16 weitergeleitet wird.

Als Sensoreinrichtung 14 können, beispielsweise bei einem mittels einer elektrischen Maschine betriebenen physikalischen oder chemischen Prozess, eine Strommesseinrichtung zur Messung eines Laststroms als Prozessparameter 8 oder bei einem mechanischen Vorgang ein Bewegungssensor zur Erfassung eines Bewegungsablaufs dienen. Weiterhin sind optische oder auch akustische Sensoreinrichtungen 14, insbesondere auch im Hinblick auf eine vorbeugende Instandhaltung, zur Messung weiterer physikalischer Größen möglich.

Ergänzend oder alternativ zu dem von der Sensoreinrichtung 14 erzeugten Prozesssignal Ip wird unmittelbar von der Prozessablaufsteuerung 7 eine analoge oder digitale Information durch das den Prozessablauf leitende Steuersignal Ix als Prozesssignal Ip der Recheneinheit 16 zugeführt.

In der Recheneinheit 16 wird das Differenzstromsignal Id mit mindestens einem der zugeführten Prozesssignale Ip korreliert und als Ergebnis ein Korrelationssignal Ic berechnet.

Falls das Korrelationssignal Ic eine zeitliche Übereinstimmung zwischen dem Differenzstromsignal Id und dem Prozesssignal Ip zeigt, beispielsweise in Form synchron auftretender Artefakte oder übereinstimmender Periodizitäten, wird durch das Signalisierungssignal Is ein Kurzzeit-Isolationsfehler Rf signalisiert.

Im Falle der Erfassung eines Laststromsignals als Prozesssignal Ip kann zusätzlich eine Verlagerungsspannung ULx zwischen einem oder mehreren der aktiven Leiter L1, L2, L3 und Erde PE mittels einer Spannungsmesseinrichtung 20 erfasst und als Verlagerungsspannungssignal Uv an die Recheneinheit 16 weitergeleitet werden, um durch Einbeziehung des Verlagerungsspannungssignals Uv mit einer weiteren Korrelationsberechnung eine zuverlässigere Erkennung eines zyklischen kurzzeitig auftretenden Isolationsfehlers Rf zu ermöglichen.

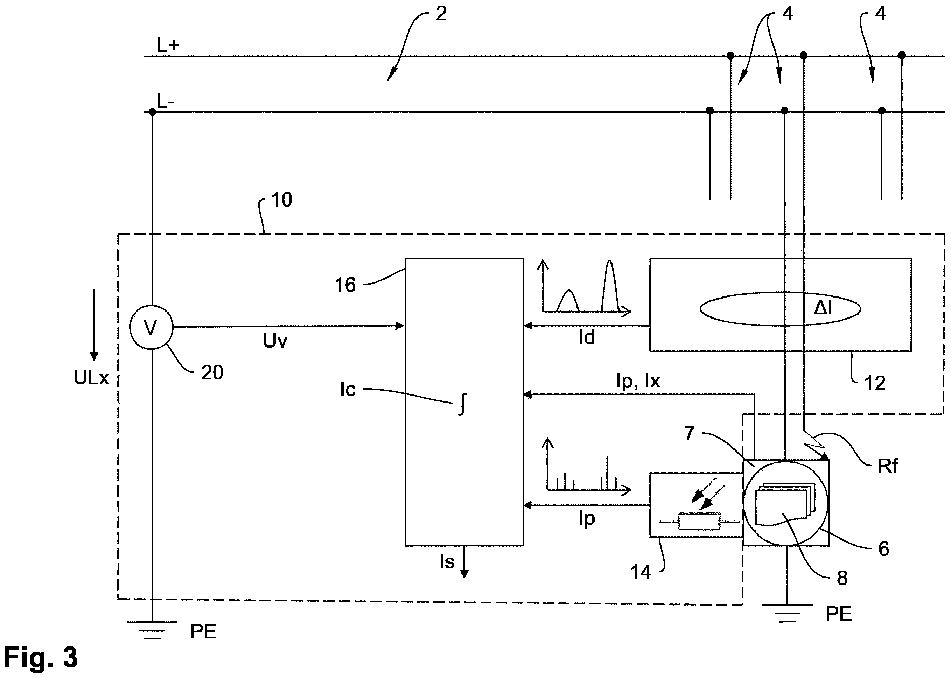

**Fig. 3** zeigt die erfindungsgemäße Vorrichtung 10 zur Erkennung und Lokalisierung von zyklisch auftretenden Kurzzeit-Isolationsfehlern Rf in Verbindung mit einem ungeerdeten Gleichspannungs-Stromversorgungssystem 2, welches die aktiven Leiter L+ und L- aufweist. Die Schaltungsstruktur der erfindungsgemäßen Vorrichtung 10 ist wie in Fig. 2 ausgeführt. Der Differenzstromsensor 12 ist neben der Eignung zur Erfassung eines Wechsel-Differenzstroms ΔI auch zum Erfassen eines Gleich-Differenzstroms ΔI ausgelegt ist, um das Differenzstromsignal Id abzuleiten.

## Patentansprüche

1. Verfahren zur Erkennung und Lokalisierung von zyklisch auftretenden Kurzzeit-Isolationsfehlern (Rf) in einem ungeerdeten Stromversorgungssystem (2) mit einem über einen Leitungszweig (4) angeschlossenen Verbraucher (6), umfassend die Verfahrensschritte:
Erfassen (S1) eines durch den Kurzzeit-Isolationsfehler (Rf) verursachten Fehlerstroms als Differenzstrom (ΔI) in dem zu überwachenden Leitungszweig (4) und Abbilden des zeitlichen Verlaufs des Differenzstroms (ΔI) durch ein Differenzstromsignal (Id) mittels eines Differenzstromsensors (12),
**gekennzeichnet durch**
Bereitstellen eines Prozesssignals (Ip), welches einen Prozessablauf eines in dem Verbraucher (6) ablaufenden Prozesses zeitlich beschreibt,
Korrelieren (S3) des Differenzstromsignals (Id) mit dem Prozesssignal (Ip) in einer Recheneinheit (16), um ein Korrelationssignal (Ic) als Maß für eine zeitliche Übereinstimmung zwischen dem Differenzstromsignal (Id) und dem Prozesssignal (Ip) zu erhalten,
Signalisieren des Kurzzeit-Isolationsfehlers (Rf) durch die Recheneinheit (16) mittels eines Signalisierungssignals (Is), falls das Korrelationssignal (Ic) die zeitliche Übereinstimmung zeigt.

2. Verfahren nach Anspruch 1,
**dadurch gekennzeichnet,**
**dass** das Prozesssignal (Ip) mittels einer Sensoreinrichtung (14) erzeugt wird durch Erfassen (S2) eines mit dem Prozess verbundenen Prozessparameters (8) und durch Abbilden des zeitlichen Verlaufs des Prozessparameters (8).

3. Verfahren nach Anspruch 2,
**dadurch gekennzeichnet,**
**dass** als Prozessparameter (8) eine den Prozessablauf beschreibende physikalische Größe oder eine daraus abgeleitete Größe erfasst wird.

4. Verfahren nach einem der Ansprüche 1 bis 3,
**dadurch gekennzeichnet,**
**dass** als Prozesssignal (Ip) ein den Prozessablauf leitendes Steuersignal (Ix) korreliert wird.

5. Verfahren nach einem der Ansprüche 1 bis 4,
**dadurch gekennzeichnet,**
**dass** als Verlagerungsspannungssignal (Uv) der zeitliche Verlauf einer Verlagerungsspannung (ULx) zwischen einem aktiven Leiter (L1, L2, L3) des ungeerdeten Stromversorgungssystems (2) und Erde (PE) mittels einer Spannungsmesseinrichtung (20) erfasst und in der Recheneinheit (16) mit dem Differenzstromsignal (Id) korreliert wird.

6. Vorrichtung (10) zur Erkennung und Lokalisierung von zyklisch auftretenden Kurzzeit-Isolationsfehlern (Rf) in einem ungeerdeten Stromversorgungssystem (2) mit einem über einen Leitungszweig (4) angeschlossenen Verbraucher (6),
mit einem Differenzstromsensor (12) zum Erfassen (S1) eines durch den Kurzzeit-Isolationsfehler (Rf) verursachten Fehlerstroms als Differenzstrom (ΔI) in dem zu überwachenden Leitungszweig (4) und zum Abbilden des zeitlichen Verlaufs des Differenzstroms (ΔI) durch ein Differenzstromsignal (Id),
**gekennzeichnet durch** ,
eine Recheneinheit (16), die konfiguriert ist zum Empfangen eines Prozesssignals (Ip), welches einen Prozessablauf eines in dem Verbraucher (6) ablaufenden Prozesses zeitlich beschreibt, zum Korrelieren (S3) des Differenzstromsignals (Id) mit dem Prozesssignal (Ip), um ein Korrelationssignal (Ic) als Maß für eine zeitliche Übereinstimmung zwischen dem Differenzstromsignal (Id) und dem Prozesssignal (Ip) zu erhalten und zum Signalisieren eines Kurzzeit-Isolationsfehlers (Rf) mittels eines Signalisierungssignals (Is), falls das Korrelationssignal (Ic) die zeitliche Übereinstimmung zeigt.

7. Vorrichtung nach Anspruch 6,
**gekennzeichnet durch**
eine Sensoreinrichtung (14), die das Prozesssignal (Ip) erzeugt durch Erfassen (S2) eines mit dem Prozess verbundenen Prozessparameters (8) und durch Abbilden des zeitlichen Verlaufs des Prozessparameters (8).

8. Vorrichtung nach Anspruch 7,
**dadurch gekennzeichnet,**
**dass** die Sensoreinrichtung (14) zum Erfassen (S2) einer den Prozessablauf beschreibende physikalische Größe oder eine daraus abgeleitete Größe als Prozessparameter (8) ausgebildet ist.

9. Vorrichtung nach einem der Ansprüche 6 bis 8,
**dadurch gekennzeichnet,**
**dass** das Prozesssignal (Ip) ein den Prozessablauf leitendes Steuersignal (Ix)ist.

10. Vorrichtung nach einem der Ansprüche 6 bis 9,
**gekennzeichnet durch**
eine Spannungsmesseinrichtung (20) zum Erfassen des zeitlichen Verlaufs einer Verlagerungsspannung (ULx) zwischen einem aktiven Leiter (L1, L2, L3) des ungeerdeten Stromversorgungssystems (2) und Erde (PE) als Verlagerungsspannungssignal (Uv), das in der Recheneinheit (16) mit dem Differenzstromsignal (Id) korreliert wird.

## Claims

1. A method for identifying and locating cyclic momentary insulation faults (Rf) in an ungrounded power supply system (2) having a consumer (6) connected via a branch circuit (4), the method comprising the steps:
detecting (S1) a fault current caused by the momentary insulation fault (Rf) as a differential current (ΔI) in the branch circuit (4) to be monitored and displaying the temporal progression of the differential current (ΔI) via a differential current signal (Id) by means of a differential current sensor (12),
**characterized by**
providing a processing signal (Ip) which temporally describes a process sequence of a process taking place in the consumer (6), correlating (S3) the differential current signal (Id) with the processing signal (Ip) in a computing unit (16) in order to yield a correlation signal (Ic) as a measure for a temporal match between the differential current signal (Id) and the processing signal (Ip), signaling the momentary insulation fault (Rf) via the computing unit (16) by means of a signaling signal (Is) if the correlation signal (Ic) shows the temporal match.

2. The method according to claim 1,
**characterized in that**
the processing signal (Ip) is generated by means of a sensor device (14) by detecting (S2) a process parameter (8) related to the process and by displaying the temporal progression of the process parameter (8).

3. The method according to claim 2,
**characterized in that**
a physical variable describing the process sequence or a variable derived therefrom is detected as a process parameter (8).

4. The method according to any one of the claims 1 to 3,
**characterized in that**
a control signal (Ix) leading the process sequence is correlated as a processing signal (Ip).

5. The method according to any one of the claims 1 to 4,
**characterized in that**
as a residual voltage signal (Uv), the temporal progression of a displacement voltage (ULx) is detected between an active conductor (L1, L2, L3) of the ungrounded power supply system (2) and ground (PE) by means of a voltage measuring device (20) and is correlated with the differential current signal (Id) in the computing unit (16).

6. A device (10) for identifying and locating cyclic momentary insulation faults (Rf) in an ungrounded power supply system (2) having a consumer (6) connected via a branch circuit (4),
the device (10) having a differential current sensor (12) for detecting (S1) a fault current caused by the momentary insulation fault (Rf) as a differential current (ΔI) in the branch circuit (4) to be monitored and for displaying the temporal progression of the differential current (ΔI) via a differential current signal (Id),
**characterized by**
a computing unit (16) which is configured for receiving a processing signal (Ip) which temporally describes a process sequence of a process taking place in the consumer (6); for correlating (S3) the differential current signal (Id) with the processing signal (Ip) in order to yield a correlation signal (Ic) as a measure for a temporal match between the differential current signal (Id) and the processing signal (Ip); and for signaling a momentary insulation fault (Rf) by means of a signaling signal (Is) if the correlation signal (Ic) shows the temporal match.

7. The device according to claim 6,
**characterized by**
a sensor device (14), which generates the processing signal (Ip) by detecting (S2) a process parameter (8) related to the process and by displaying the temporal progression of the process parameter (8).

8. The device according to claim 7,
**characterized in that**
the sensor device (14) is configured for detecting (S2) a physical variable describing the process sequence or a variable derived therefrom as a process parameter (8).

9. The device according to any one of the claims 6 to 8,
**characterized in that**
the processing signal (Ip) is a control signal (Ix) operating the process sequence.

10. The device according to any one of the claims 6 to 9,
**characterized by**
a voltage measuring device (20) for detecting the temporal progression of a displacement voltage (ULx) between an active conductor (L1, L2, L3) of the ungrounded power supply system (2) and ground (PE) as a displacement voltage signal (Uv), which is correlated with the differential current signal (Id) in the computing unit (16).

## Revendications

1. Procédé d'identification et de localisation de défauts d'isolement (Rf) cycliques de courte durée dans un système d'alimentation électrique (2) non mis à la terre et ayant un consommateur (6) connecté par un circuit terminal (4), le procédé comprenant les étapes suivantes :
la détection (S1) d'un courant de défaut causé par le défaut d'isolement (Rf) de courte durée en tant que courant différentiel (ΔI) dans le circuit terminal (4) à surveiller et l'affichage de la progression temporelle du courant différentiel (ΔI) par un signal de courant différentiel (Id) au moyen d'un capteur de courant différentiel (12),
**caractérisé par**
la fourniture d'un signal de traitement (Ip) qui décrit temporellement une séquence d'un processus se déroulant dans le consommateur (6),
la corrélation (S3) du signal de courant différentiel (Id) avec le signal de traitement (Ip) dans une unité de compte (16) afin de produire un signal de corrélation (Ic) comme mesure d'une correspondance temporelle entre le signal (Id) de courant différentiel et le signal de traitement (Ip),
la signalisation du défaut d'isolement (Rf) de courte durée par l'unité de compte (16) au moyen d'un signal de signalisation (Is) si le signal de corrélation (Ic) montre la correspondance temporelle.

2. Procédé selon la revendication 1,
**caractérisé en ce que**
le signal de traitement (Ip) est généré au moyen d'un dispositif de capteur (14) en détectant (S2) un paramètre de processus (8) lié au processus et en affichant la progression temporelle du paramètre de processus (8).

3. Procédé selon la revendication 2,
**caractérisé en ce**
**qu'**une variable physique décrivant la séquence du procédé ou une variable dérivée de celle-ci est détectée en tant que paramètre du procédé (8).

4. Procédé selon l'une des revendications 1 à 3,
**caractérisé en ce**
**qu'**un signal de commande (Ix) menant la séquence de processus est corrélé comme signal de traitement (Ip).

5. Procédé selon l'une quelconque des revendications 1 à 4,
**caractérisé en ce que**
la progression temporelle d'une tension résiduelle (ULx) est détectée en tant que signal de tension résiduelle (Uv) entre un conducteur actif (L1, L2, L3) du système d'alimentation électrique (2) non mis à la terre et la terre (PE) au moyen d'un dispositif (20) de mesure de la tension et est corrélée avec le signal (Id) de courant différentiel dans l'unité de compte (16).

6. Dispositif (10) pour identifier et localiser des défauts d'isolement (Rf) cycliques de courte durée dans un système d'alimentation électrique (2) non mis à la terre et ayant un consommateur (6) connecté par un circuit terminal (4),
le dispositif (10) ayant un capteur (12) de courant différentiel pour détecter (S1) un courant de défaut causé par le défaut d'isolement (Rf) de courte durée en tant que courant différentiel (ΔI) dans le circuit terminal (4) à surveiller et pour afficher la progression temporelle du courant différentiel (ΔI) par un signal de courant différentiel (Id),
**caractérisé par**
une unité de compte (16) configurée pour recevoir un signal de traitement (Ip) qui décrit temporellement une séquence de processus se déroulant dans le consommateur (6) ; pour corréler (S3) le signal (Id) de courant différentiel avec le signal de traitement (Ip) afin de produire un signal de corrélation (Ic) comme mesure d'une correspondance temporelle entre le signal (Id) de courant différentiel et le signal de traitement (Ip) ; et pour signaler un défaut d'isolement (Rf) de courte durée au moyen d'un signal de signalisation (Is) si le signal de corrélation (Ic) montre la correspondance temporelle.

7. Dispositif selon la revendication 6,
**caractérisé par**
un dispositif de capteur (14) qui génère le signal de traitement (Ip) en détectant (S2) un paramètre de processus (8) lié au processus et en affichant la progression temporelle du paramètre de processus (8).

8. Dispositif selon la revendication 7,
**caractérisé en ce que**
le dispositif de capteur (14) est configuré pour détecter (S2) une variable physique décrivant la séquence de processus ou une variable dérivée de celle-ci en tant que paramètre de processus (8).

9. Dispositif selon l'une quelconque des revendications 6 à 8,
**caractérisé en ce que**
le signal de traitement (Ip) est un signal de commande (Ix) menant la séquence de processus.

10. Dispositif selon l'une quelconque des revendications 6 à 9,
**caractérisé par**
un dispositif (20) de mesure de tension pour détecter la progression temporelle d'une tension résiduelle (ULx) entre un conducteur actif (L1, L2, L3) du système d'alimentation électrique non mis à la terre (2) et la terre (PE) en tant que signal (Uv) de tension résiduelle, qui est corrélé avec le signal (Id) de courant différentiel dans l'unité de compte (16).
